Europäisches Patentamt

(19) European Patent Office

Office européen des brevets

(11) Numéro de publication: **0 146 446**
**B1**

(12) **FASCICULE DE BREVET EUROPEEN**

(45) Date de publication du fascicule du brevet:
08.11.89

(51) Int. Cl.⁴: **H 01 L 21/306,** H 01 L 21/205,
**H 01 J 13/32**

(21) Numéro de dépôt: 84402320.0

(22) Date de dépôt: 14.11.84

(54) Procédé et dispositif de traitement d'une matériau semiconducteur, par plasma.

(30) Priorité: 17.11.83 FR 8318300

(43) Date de publication de la demande:
26.06.85 Bulletin 85/26

(45) Mention de la délivrance du brevet:
08.11.89 Bulletin 89/45

(84) Etats contractants désignés:
DE GB NL

(73) Titulaire: **ETAT FRANCAIS représenté par le Ministre des PTT (Centre National d'Etudes des Télécommunications), 38-40 rue du Général Leclerc, F-92131 Issy-les-Moulineaux (FR)**
Titulaire: **CENTRE NATIONAL DE LA RECHERCHE SCIENTIFIQUE (CNRS), 15, Quai Anatole France, F-75007 Paris (FR)**

(72) Inventeur: **Bouchoule, André, 60, rue des Cireries, F-45160 Olivet (FR)**
Inventeur: **Ranson, Pierre, 23, rue Auguste Renoir, F-45100 Orleans (FR)**
Inventeur: **Henry, Daniel, Le Chemin des Combes, F-38700 Le Sappey en Chartreuse (FR)**

(74) Mandataire: Mongrédien, André et al, c/o
BREVATOME 25, rue de Ponthieu, F-75008 Paris (FR)

(56) Documents cités:
EP-A- 0 090 067
DE-A- 3 322 680
FR-A- 2 332 616
US-A- 4 285 762

CHEMICAL ABSTRACTS, vol. 100, 1984, page 597, no. 94956z, Columbus, Ohio, US; & JP - A - 58 177 135 (TOSHIBA CORP.) 17-10-1983
PATENTS ABSTRACTS OF JAPAN, vol. 7, no. 3 (C-143)[1148], 7 Janvier 1983; & JP - A - 57 161 057 (MITSUBISHI DENKI K.K.) 04-10-1982
CHEMICAL ABSTRACTS, vol. 100, 1984, page 626, no. 166357e, Columbus, Ohio, US; Y.L. KHAIT et al.:

(56) Documents cités: (suite)
"Mechanism in the plasma-substrate region in a low pressure microwave plasma" & SYMP. PROC. - INT. SYMP. PLASMA CHEM., 6th 1983, 3, 729-36
CHEMICAL ABSTRACTS, vol. 100, 1984, page 626, no. 166358f, Columbus, Ohio, US; G. KAGANOWICZ et al.:
"Spatial effects in plasma deposition of silicon oxide (SiO2) using magnetically enhanced glow discharge" & SYMP. PROC. - INT. SYMP. PLASMA CHEM., 6th 1983, 3, 792-8
CHEMICAL ABSTRACTS, vol. 88, no. 6, 6 février 1978, page 435, no. 44129v, Columbus, Ohio, US; & JP - A - 77 88 238 (SEMICONDUCTOR RESEARCH FOUNDATION) 23-07-1977

## Description

La présente invention concerne un procédé et un dispositif de traitement d'un matériau semiconducteur, par plasma. Elle s'applique notamment à la gravure d'un matériau semiconducteur, par exemple de plaquettes semiconductrices destinées à la fabrication de circuits intégrés, le mot «gravure» étant pris dans un sens très large «d'enlèvement de matière» suivant une géométrie prédéterminée ou quelconque. L'invention s'applique également au dépôt d'une matière sur le matériau ainsi qu'à la croissance de couches sur un substrat et, plus généralement, au traitement de surfaces.

On connaît déjà des machines pour le traitement de matériaux semiconducteurs, utilisant le procédé de gravure ionique réactive. Ces machines présentent l'inconvénient majeur d'effectuer la gravure très lentement (à une vitesse de l'ordre de 100 nm/mn pour le silicium et les siliciures et 50 nm/mn pour la silice). Du fascicule du brevet EP-A 0 090 067 est connu un réacteur pour la gravure ionique réactive de coup semiconducteurs. Des champs magnétiques locaux parallèles et perpendiculaires au champ électrique produisant le plasma sont crées par des moyens intérieurs au tube de réaction.

La présente invention a pour objet un procédé et un dispositif de traitement d'un matériau semiconducteur qui améliorent la sélectivité ou qui permettent des vitesses de gravure nettement plus importantes.

De façon précise, la présente invention a tout d'abord pour objet un procédé de traitement d'un matériau semiconducteur, consistant à placer le matériau dans une enceinte électriquement isolante et à le soumettre, dans l'enceinte, à un plasma d'un composé gazeux approprié au traitement, ce plasma étant obtenu par l'action d'un champ magnétique uniforme, dans l'enceinte et d'un champ électromagnétique radio-fréquence qui est produit dans l'enceinte, dans le domaine d'action du champ magnétique uniforme, et dont la composante magnétique est perpendiculaire au champ magnétique uniforme, les deux champs étant produits par des moyens extérieurs à cette enceinte.

Par «composé gazeux», on entend un gaz pur ou un mélange gazeux.

Par «traitement», on entend aussi bien la gravure du matériau que le dépôt d'une matière sur celui-ci.

Par «champ électromagnétique radio-fréquence», on entend un champ électromagnétique dont la fréquence est inférieure à 10GHz.

Bien entendu, le matériau peut être préparé de façon appropriée, en fonction du traitement qu'il doit subir et préalablement à ce traitement. Par exemple, dans le cas de la gravure de plaquettes semiconductrices destinées à la fabrication de circuits intégrés, on peut être amené à recouvrir ces plaquettes d'une couche discontinue (masque) de résine, de $Si_3N_4$, de silice ..., avant de les traiter selon l'invention, pour ne graver que des domaines prédéterminés des plaquettes.

Selon un mode de mise en œuvre particulier du procédé objet de l'invention, le traitement est une gravure du matériau et le composé gazeux comprend au moins un gaz susceptible de donner, par décomposition, un élément apte à se combiner avec au moins l'un des éléments constituant le matériau pour donner un composé volatil.

Dans le cas où le matériau à graver est du silicium, le composé gazeux comprend, de préférence, de l'argon et de l'hydrogène, mélange qui présente un grand intérêt comme on le verra par la suite.

Selon un autre mode de mise en œuvre particulier du procédé objet de l'invention, le traitement est un dépôt d'une matière sur le matériau et le composé gazeux comporend au moins un gaz apte à donner la matière par décomposition.

La présente invention a également pour objet un dispositif de traitement d'un matériau semiconducteur comprenant:

- une enceinte électriquement isolante,
- des moyens de support du matériau dans l'enceinte,
- des moyens d'introduction dans l'enceinte et d'évacuation de celle-ci, d'un composé gazeux approprié au traitement,
- des moyens de production, extérieurs à l'enceinte, d'un champ magnétique uniforme dans l'enceinte, et
- des moyens, extérieurs à l'enceinte, de production d'un champ électromagnétique radio-fréquence dans cette enceinte, dans le domaine d'action du champ magnétique uniforme, le champ électromagnétique radio-fréquence étant tel que sa composante magnétique soit perpendiculaire au champ magnétique uniforme de manière à traiter le matériau en le soumettant à un plasma obtenu par ionisation du composé gazeux présent dans l'enceinte et soumis au champ magnétique uniforme et au champ électromagnétique radio-fréquence.

Selon un mode de réalisation particulier du dispositif objet de l'invention, l'enceinte présente la forme d'un tube et le champ magnétique uniforme est parallèle à l'axe du tube.

Enfin, selon un autre mode de réalisation particulier, le matériau se présente sous forme d'une pluralité de plaquettes et les moyens de support sont mobiles et aptes à maintenir les plaquettes perpendiculairement à l'axe du tube.

L'invention sera mieux comprise à la lecture de la description qui suit, d'exemples de réalisation donnés à titre indicatif et nullement limitatif, en référence aux dessins annexés sur lesquels:

- la figure 1 est une vue schématique d'un mode de réalisation particulier du dispositif objet de l'invention, et
- les figures 2 et 3 mettent en évidence l'intérêt de l'invention en ce qui concerne les gravures respectivement isotrope et anisotrope du silicium.

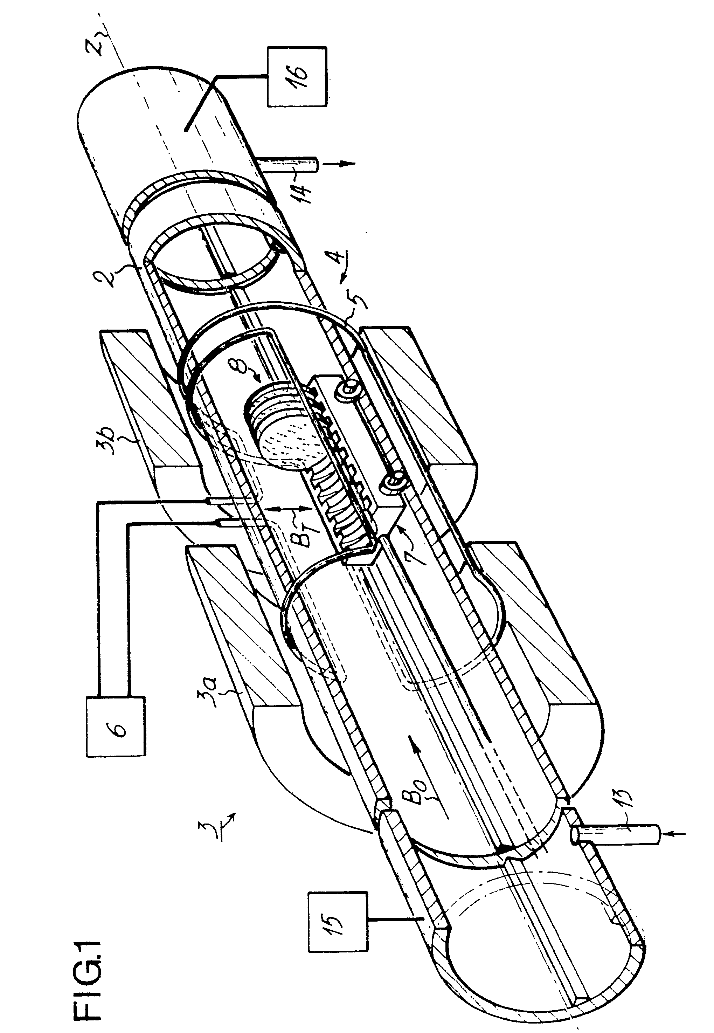

Sur la figure 1, on a représenté schématiquement un mode de réalisation particulier du dispositif objet de l'invention. Celui-ci comprend:

– une enceinte 2 électriquement isolante,

– des moyens 3 de production d'un champ magnétique uniforme $B_O$ dans l'enceinte, et

– des moyens 4 de production d'un champ électromagnétique radio-fréquence dans l'enceinte, tel que sa composante magnétique $B_T$ soit perpendiculaire au champ magnétique uniforme $B_O$.

Par exemple, l'enceinte 2 consiste en un tube en quartz d'axe Z, les moyens 3 de production du champ uniforme $B_O$ sont constitués part deux bobines magnétiques 3a et 3b qui entourent le tube 2 et sont convenablement alimentées en courant électrique continu par des moyens non représentés, et les moyens 4 de production du champ radio-fréquence comprennent une antenne quadrifilaire 5 et une source radio-fréquence 6 pour alimenter l'antenne. Cette dernière entoure le tube 2, dans l'espace compris entre celui-ci et les deux bobines 3a et 3b.

L'antenne 5 peut être schématiquement considérée comme étant composée de deux boucles électriquement conductrices formant bobines de Helmholtz et diamétralement opposées de part et d'autre du tube 2, dans le domaine d'action des bobines 3a et 3b. L'association du tube 2, du champ uniforme $B_O$ et de l'antenne 5, prévue pour produire un champ électromagnétique dont la composante magnétique est perpendiculaire au champ uniforme $B_O$, en vue de créer un plasma dans le tube, est d'ailleurs déjà connue par l'article de R.W. Boswell, publié dans Physics Letters, vol. 33A, n° 7, 11 décembre 1970, p. 457 et 458, mais sans mention d'application particulière du plasma.

Le dispositif représenté sur la figure 1 comprend également des moyens 7 de support du matériau 8 à traiter dans le domaine d'action des champs $B_O$ et $B_T$.

Sur la figure 1, on aperçoit également un conduit 13 pour introduire dans le tube 2 un composé gazeux approprié au traitement du matériau 8 et un autre conduit 14 pour évacuer ce composé en direction de moyens de pompage non représentés. Des jauges 15 et 16 permettent de mesurer la pression régnant dans le tube. En outre, un sas non représenté est prévu au moins à l'une des extrémités du tube, pour introduire dans celui-ci le matériau 8 et évacuer ce matériau une fois traité.

Le dispositif décrit en référence à la figure 1 appartient à la catégorie des machines dites «tubulaires» qui travaillent à basse pression (comprise entre environ 0,1 et 10 pascals et en tout cas inférieure à $10^2$ pascals) et dans lesquelles les énergies mises en jeu ne dépassent pas 10 eV environ et sont en tout cas inférieures à 100 eV. D'autre part, le système décrit permet d'appliquer une polarisation du porte substrat indépendamment de la création du plasma.

Ce dispositif permet de créer une colonne de plasma dans le tube, sous l'action du champ radio-fréquence $B_T$ couplé au champ uniforme $B_O$, ce dernier ayant une intensité faible, comprise entre environ quelques millièmes et quelques dixièmes de tesla. L'intérêt de la présente invention réside dans la remarquable efficacité de couplage radio-fréquence (la fréquence industrielle de 13,56 MHz étant d'ailleurs bien adaptée à l'invention) de l'antenne excitatrice 5, ce qui conduit à la production de plasmas de densités très importantes en regard des densités de puissance électromagnétique utilisées: on peut par exemple obtenir des densités de l'ordre de quelques $10^{12}$ électrons par $cm^3$ avec des densités de puissance de l'ordre de 0,1 à 1 W par $cm^3$ selon le type de composé gazeux utilisé. La possibilité d'engendrer des densités électroniques élevées confère au dispositif de l'invention des caractéristiques inédites, en particulier dans le domaine de la gravure d'un matériau semiconducteur tel que le silicium monocristallin ou polycristallin, la gravure du silicium étant de préférence réalisée dans l'invention à l'aide d'un mélange gazeux hydrogène-argon.

Avec ce mélange, l'invention permet une gravure très sélective du silicium par rapport à la silice $SiO_2$ et au nitrure de silicium $Si_3N_4$, la sélectivité (rapport de la vitesse de gravure du silicium à la vitesse de gravure de $SiO_2$ ou $Si_3N_4$) étant de l'ordre de 30 à 50, voire supérieure à ces valeurs. Le tableau I suivant donne des conditions expérimentales aboutissant à de telles valeurs ainsi qu'à des vitesses $V_{Si}$ élevées de gravure pour le silicium polycristallin.

Tableau I

| Pression totale (Pa) | Densité de puissance (W/dm³) | Débit d'argon (cm³/mn) | Débit de H₂ (cm³/mn) | $V_{Si}$ μm/mn | Sélectivité |
|---|---|---|---|---|---|
| 1,3 | 320 | 4 | 8 | 0,20 | 30 à 50 |
| 1,3 | 320 | 4 | 20 | 0,35 | 30 à 50 |

Les molécules d'hydrogène sont dissociées dans le plasma et les atomes d'hydrogène réagissent avec le silicium pour donner le composé volatil $SiH_x$, avex x inférieur ou égal à quatre. L'argon catalyse cette réaction en favorisant la dissociation des molécules d'hydrogène.

Le mélange hydrogène-argon utilisé avec l'invention, permet en outre de graver le silicium en prédéterminant la pente de gravure, cette pente étant fonction de la concentration relative de l'argon dans l'hydrogène. En particulier, on peut obtenir une gravure parfaitement isotrope pour une faible concentration relative d'argon, une gravure parfaitement anisotrope pour une concentration relative d'argon égale à 50%, ainsi que des configurations intermédiaires, comme le montre le tableau II suivant:

Tableau II

| Pression total (Pa) | Densité de puissance (W/dm³) | Proportion de $H_2$ | Proportion d'argon | Pente |
|---|---|---|---|---|
| 0,79 | 320 | 1 | 1 | 90° |
| 1,3 | 320 | 2,5 | 1 | isotrope |
| 1,3 | 320 | 3,75 | 1 | 45–50° |
| 1,3 | 320 | 5 | 1 | 70° |
| 1,3 | 320 | 8 | 1 | 60° |

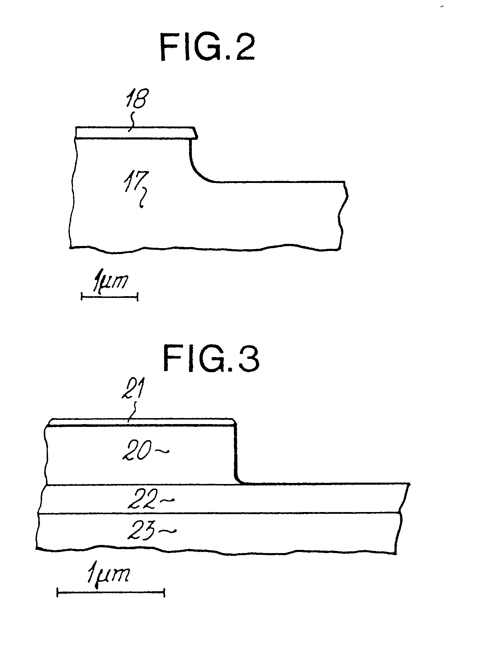

A titre d'exemple, on a représenté sur la figure 2 la gravure isotrope d'un substrat 17 de Si <100> recouvert d'un masque 18 de $SiO_2$, gravure obtenue à l'aide d'un mélange de 95% d'hydrogène et de 5% d'argon, la vitesse de gravure du silicium étant de l'ordre de 0,2 à 0,3 µm/mn et la sélectivité (par rapport à $SiO_2$) au moins égale à 50, et sur la figure 3, la gravure parfaitement anisotrope d'une couche 20 de silicium polycristallin recouverte d'un masque 21 en aluminium et déposée sur une couche 22 de $SiO_2$, elle-même déposée sur un substrat 23 de Si <100>, gravure obtenue à l'aide d'un mélange de 50% d'hydrogène et de 50% d'argon, la vitesse de gravure du silicium étant de l'ordre de 0,15 à 0,2 µm/mn et la sélectivité (par rapport à $SiO_2$) au moins égale à 30, avec dans les deux cas (figures 2 et 3) une densité de puissance du champ radio-fréquence (13,56 MHz) de 300 W/cm³, un champ uniforme $B_o$ de $5.10^{-3}$ T, une pression totale de 0,79 Pa et un débit gazeux de l'ordre de 0,3 dm³/mn.

La variation du profil du silicium gravé est obtenue sans consommation du masque ni adjonction d'une polarisation externe sur le substrat.

Par comparaison, une gravure ionique réactive classique de silicium polycristallin, réalisée à l'aide de $SF_6$ pur, avec une pression de 0,66 Pa, un débit de 15 cm³/mn, une densité de puissance de 40 W/dm³, est anisotrope et s'effectue avec une vitesse de l'ordre de 0,1 µm/mn et une sélectivité de l'ordre de 2 à 4 par rapport à $SiO_2$.

L'invention permet donc une gravure du silicium avec un mélange hydrogène-argon qui est facile à utiliser (comparativement aux gaz chlorés employés dans les installations de l'art antérieur, gaz permettant une bonne sélectivité mais dont l'emploi est délicat, pose des problèmes de sécurité et de tenue des matériaux et oblige à éviter impérativement la présence de vapeur d'eau dans l'appareil de gravure) et permet une sélectivité, par rapport à $SiO_2$ ou $Si_3N_4$, au moins égale à celles qui sont obtenues dans l'art antérieur. En outre, avec ce mélange, l'invention permet la gravure du silicium avec une pente qui varie continuement avec les concentrations relatives d'argon et d'hydrogène.

Bien entendu, l'invention peut être utilisée dans le domaine de la gravure avec des mélanges gazeux autres que le mélange hydrogène-argon, par exemple avec un mélange comprenant un halogène tel que le chlore ou le fluor sous forme gazeuse inerte, un oxydant tel que l'oxygène, un réducteur tel que l'hydrogène et un gaz neutre tel qu'un gaz rare (l'argon par exemple). On peut également utiliser avec l'invention des gaz fluorés, carbono-fluorés ou chlorés ainsi que tous les mélanges obtenus à partir de ces gaz et d'adjuvants tels que $H_2$ ou $O_2$. L'invention permet par exemple la gravure à très grande vitesse du silicium polycristallin à l'aide de $SF_6$ pur comme le montre le tableau III suivant:

Tableau III

| Débit $SF_6$ (cm³/mn) | Puissance radio-fréquence (W) | Densité de puissance (W/dm³) | Pression $SF_6$ (Pa) | Vitesse de gravure (µm/mn) |
|---|---|---|---|---|
| 10 | 200 | 250 | 0,66 | 0,08 |
| 10 | 200 | 250 | 1,38 | 2 |
| 10 | 200 | 250 | 1,97 | 3,5 |
| 10 | 200 | 250 | 2,63 | 3,8 |
| 10 | 320 | 400 | 1,58 | 5 |

L'invention permet également de déposer sur un substrat, un matériau tel que le silicium, en utilisant $SiH_4$ en tant que composé gazeux: ce dernier se décompose en hydrogène et en silicium qui se dépose sur le substrat.

On peut aussi utiliser le dispositif selon l'invention pour la gravure en créant un plasma, à partir de tout gaz fluoré, carbono-fluoré ou chloré. Dans tous les cas, on constate une vitesse de gravure nettement supérieure à celle obtenue dans les dispositifs classiques.

L'invention peut s'appliquer en conséquence:

– à la réalisation de tranchées pour caissons d'isolement, de l'ordre de 1 µm de largeur et 5 µm de profondeur,

– à l'amorce de chemins de découpe avant clivage,

– à la réalisation de marques d'alignement pour masqueurs électroniques,

– à la gravure de la face arrière de plaquettes semiconductrices pour y réaliser une prise de contact,

– à l'amincissement et à la mise à épaisseur des plaquettes (par exemple avant leur montage dans des boîtiers), et

– au nettoyage d'objets souillés par un matériau semiconducteur: par exemple au nettoyage de nacelles en quartz après dépôt de silicium polycristallin, par CVD, LPCVD ou PECVD.

**Revendications**

1. Procédé de traitement d'un matériau semiconducteur, consistant à placer le matériau (8) dans une enceinte électriquement isolante (2) et à le soumettre, dans l'enceinte, à un plasma d'un composé gazeux approprié au traitement, ce plasma étant obtenu par l'action d'un champ magnétique ($B_O$) uniforme dans l'enceinte (2) et d'un champ électromagnétique radio-fréquence qui est produit dans l'enceinte (2), dans le domaine d'action du champ magnétique uniforme, et dont la composante magnétique ($B_T$) est perpendiculaire au champ magnétique uniforme, les deux champs ($B_O$, $B_T$) étant produits par des moyens extérieurs à cette enceinte.

2. Procédé selon la revendication 1, caractérisé en ce que le champ électromagnétique radio-fréquence est engendré par une antenne quadrifilaire (5) qui entoure l'enceinte (2), dans le domaine d'action du champ magnétique uniforme, et qui est alimentée par une source radio-fréquence (6).

3. Procédé selon l'une quelconque des revendications 1 et 2, caractérisé en ce que le traitement est une gravure du matériau et en ce que le composé gazeux comprend au moins un gaz susceptible de donner, par décomposition, un élément apte à se combiner avec au moins l'un des éléments constituant le matériau pour donner un composé volatil.

4. Procédé selon la revendication 3, caractérisé en ce que le composé gazeux est un composé fluoré, carbono-fluoré ou chloré.

5. Procédé selon la revendication 3, caractérisé en ce que le matériau est du silicium et en ce que le composé gazeux comprend de l'argon et de l'hydrogène.

6. Procédé selon l'une quelconque des revendications 3 à 5, caractérisé en ce que le matériau se présente sous forme d'au moins une plaquette destinée à la fabrication de circuits intégrés et recouverte d'une couche protectrice discontinue délimitant des bandes sur la plaquette, pour y réaliser des tranchées pour caissons d'isolement ou y amorcer des chemins de découpe avant clivage.

7. Procédé selon l'une quelconque des revendications 1 et 2, caractérisé en ce que le traitement est un dépôt d'une matière sur le matériau et en ce que le composé gazeux comprend au moins un gaz apte à donner la matière par décomposition.

8. Dispositif de traitement d'un matériau semiconducteur comprenant:

– une enceinte électriquement isolante (2),

– des moyens (7) de support du matériau (8) dans l'enceinte,

– des moyens (13, 14) d'introduction dans l'enceinte et d'évacuation de celle-ci, d'un composé gazeux approprié au traitement,

– des moyens (3) extérieurs à l'enceintes de production d'un champ magnétique ($B_O$) uniforme dans l'enceinte, et

– des moyens (4), extérieurs à l'enceinte, de production d'un champ électromagnétique radio-fréquence dans cette enceinte, dans la domaine d'action du champ magnétique uniforme, le champ électromagnétique radio-fréquence étant tel que sa composante magnétique ($B_T$) soit perpendiculaire au champ magnétique uniforme de manière à traiter le matériau en le soumettant à un plasma obtenu par ionisation du composé gazeux présent dans l'enceinte et soumis au champ magnétique uniforme ($B_O$) et au champ électromagnétique radio-fréquence.

9. Dispositif selon la revendication 8, caractérisé en ce que les moyens (4) de production du champ électromagnétique radio-fréquence comprennent une antenne quadrifilaire (5) qui entoure l'enceinte (2) dans le domaine d'action du champ magnétique uniforme, et une source radio-fréquence (6) pour alimenter l'antenne (5).

10. Dispositif selon l'une quelconque des revendications 8 et 9, caractérisé en ce que l'enceinte (2) présente la forme d'un tube et en ce que le champ magnétique uniforme ($B_O$) est parallèle à l'axe (Z) du tube.

**Claims**

1. Process for treating a semiconductor material, consisting in placing the material (8) in an electrically insulating enclosure (2) and subjecting it, in the enclosure, to a plasma of a gaseous compound which is appropriate to the treatment, this plasma being obtained by the action of a uniform magnetic field ($B_O$) in the enclosure (2) and of a radio-frequency electromagnetic field which is produced in the enclosure (2), in the region of action of the uniform magnetic field, and whose magnetic component ($B_T$) is perpendicular to the uniform magnetic field, the two fields ($B_O$, $B_T$) being produced by means external to this enclosure.

2. Process according to Claim 1, characterized in that the radio-frequency electromagnetic field is generated by a four-wire antenna (5) which surrounds the enclosure (2), in the region of action of the uniform magnetic field, and which is fed by a radio-frequency source (6).

3. Process according to either of Claims 1 and 2, characterized in that the treatment is an etching of the material and in that the gaseous compound includes at least one gas capable of giving, on decomposition, an element capable of combining with at least one of the constituent elements of the material to give a volatile compound.

4. Process according to Claim 3, characterized in that in that the gaseous compound is a fluorine, carbonfluorine or chlorine compound.

5. Process according to Claim 3, characterized in that the material is silicon and in that the gaseous compound comprises argon and hydrogen.

6. Process according to any one of Claims 3 to 5, characterized in that the material is in the form of at least one wafer intended for the manufacture of integrated circuits and coated with a noncontinuous protective layer defining bands on the wafer, for producing therein trenches for insulation boxes or for initiating therein sectioning pathways before cleavage.

7. Process according to either of Claims 1 and 2, characterized in that the treatment is a deposition of a substance on the material and in that the gaseous compound includes at least one gas capable of giving the substance by decomposition.

8. Device for treating a semiconductor material, comprising:
   − an electrically insulating enclosure (2),
   − means (7) for supporting the material (8) in the enclosure,
   − means (13, 14) for introducing into the enclosure and for removing therefrom a gaseous compound which is appropriate to the treatment,
   − means (3), external to the enclosure, for producing a uniform magnetic field ($B_O$) in the enclosure, and
   − means (4), external to the enclosure, for producing a radio-frequency electromagnetic field in this enclosure, in the region of action of the uniform magnetic field, the radio-frequency electromagnetic field being such that its magnetic component ($B_T$) is perpendicular to the uniform magnetic field, so as to treat the material by subjecting it to a plasma obtained by ionization of the gaseous compound present in the enclosure and subjected to the uniform magnetic field ($B_O$) and to the radio-frequency electromagnetic field.

9. Device according to Claim 8, characterized in that the means (4) for producing the radio-frequency electromagnetic field comprise a four-wire antenna (5) which surrounds the enclosure (2) in the region of action of the uniform magnetic field, and a radio-frequency source (6) for feeding the antenna (5).

10. Device according to either of Claims 8 and 9, characterized in that the enclosure (2) is in the shape of a tube and in that the uniform magnetic field ($B_O$) is parallel to the axis (Z) of the tube.

**Patentansprüche**

1. Verfahren zur Plasmabehandlung von Halbleitermaterial, welches darin besteht, daß das Material (8) in einer elektrisch isolierenden Umhüllung (2) angeordnet wird und daß es in der Umhüllung einem Plasma einer zur Behandlung geeigneten Gasverbindung ausgesetzt wird, wobei dieses Plasma durch die Wirkung eines in der Umhüllung (2) gleichförmigen Magnetfeldes ($B_O$) und eines elektromagnetischen Hochfrequenzfeldes erhalten wird, welch letzteres in der Umhüllung (2) im Wirkungsbereich des gleichförmigen Magnetfeldes erzeugt wird und dessen magnetische Komponente ($B_T$) senkrecht zu dem gleichförmigen Magnetfeld steht, und wobei die beiden Felder ($B_O$, $B_T$) mit außerhalb der Umhüllung liegenden Mitteln erzeugt werden.

2. Verfahren nach Anspruch 1, dadurch gekennzeichnet, daß das elektromagnetische Hochfrequenzfeld über eine Vierdrahtantenne (5) erzeugt wird, welche die Umhüllung (2) im Wirkungsbereich des gleichförmigen Magnetfeldes umgibt und welche von einer Hochfrequenzquelle (6) gespeist wird.

3. Verfahren nach Anspruch 1 oder 2, dadurch gekennzeichnet, daß die Behandlung eine Materialabtragung ist und daß die Gasverbindung mindestens ein Gas aufweist, welches in der Lage ist, durch Zersetzung ein Element abzugeben, das geeignet ist, sich mit mindestens einem der das Material bildenden Elemente zu verbinden, um eine flüchtige Verbindung abzugeben.

4. Verfahren nach Anspruch 3, dadurch gekennzeichnet, daß die Gasverbindung eine Fluor-, Kohlenstoff-Fluor- oder Chlor-Verbindung ist.

5. Verfahren nach Anspruch 3, dadurch gekennzeichnet, daß das Material aus Silizium besteht und daß die Gasverbindung Argon und Wasserstoff enthält.

6. Verfahren nach einem der Ansprüche 3 bis 5, dadurch gekennzeichnet, daß das Material die Form mindestens einer Platte aufweist, welche zur Herstellung von integrierten Schaltkreisen bestimmt ist und welche mit einer unterbrochenen Schutzschicht bedeckt ist, welche auf der Platte Streifen begrenzt, um darauf Einschnitte für Isolationsfelder auszubilden oder um darauf Schnittbahnen vor dem Teilen einzuritzen.

7. Verfahren nach einem der Ansprüche 1 oder 2, dadurch gekennzeichnet, daß die Behandlung eine Materialablagerung auf dem Material ist und daß die Gasverbindung mindestens ein Gas enthält, welches geeignet ist, durch Zersetzung das Material abzugeben.

8. Vorrichtung zur Behandlung eines Halbleitermaterials, welche aufweist:
   − eine elektrisch isolierende Umhüllung (2),
   − Mittel (7) zum Tragen des Materials (8) innerhalb der Umhüllung,
   − Mittel (13, 14) zum Einführen einer zur Behandlung geeigneten Gasverbindung in die Umhüllung und zum Abziehen der Gasverbindung aus dieser Umhüllung,
   − Mittel (3) außerhalb der Umhüllung zur Erzeugung eines gleichförmigen Magnetfeldes ($B_O$) in der Umhüllung und
   − Mittel (4) außerhalb der Umhüllung zur Erzeugung eines elektromagnetischen Hochfrequenzfeldes in dieser Umhüllung im Wirkungsbereich des gleichförmigen Magnetfeldes, wobei das elektromagnetische Hochfrequenzfeld derart ist, daß seine magnetische Komponente ($B_T$) senkrecht zu dem magnetischen Gleichfeld steht, um das Material zu behandeln, indem es einem Plasma unterworfen wird, welches durch Ionisation der in der Umhüllung anwesenden und dem gleichförmigen Magnetfeld ($B_O$) sowie dem elektromagnetischen Hochfrequenzfeld unterworfenen Gasverbindung erhalten wird.

9. Vorrichtung nach Anspruch 8, dadurch gekennzeichnet, daß die Mittel (4) zur Erzeugung des elektromagnetischen Hochfrequenzfeldes eine Vierdrahtantenne (5), welche die Umhüllung (2) im Wirkungsbereich des magnetischen Gleichfeldes umgibt, sowie eine Hochfrequenzquelle (6) zur Speisung der Antenne (5) umfassen.

10. Vorrichtung nach einem der Ansprüche 8 oder 9, dadurch gekennzeichnet, daß die Umhüllung (2) die Form einer Röhre aufweist und daß das magnetische Gleichfeld ($B_O$) parallel zur Achse (Z) der Röhre verläuft.

FIG.1

EP 0 146 446 B1

# FIG.2

_18_

_17_

_1μm_

# FIG.3

_21_

_20~_

_22~_

_23~_

_1μm_